# EUROPÄISCHE PATENTSCHRIFT

(11) **EP 0 249 122 B1**
(45) Veröffentlichungstag und Bekanntmachung des Hinweises auf die Patenterteilung: **21.04.1993**
(21) Anmeldenummer: 87107918.2
(22) Anmeldetag: 02.06.1987
(51) Int. Cl.: H01L 29/10, H01L 29/72, H01L 29/08, H01L 29/60

(54) **Abschaltbares Leistungshalbleiterbauelement**
Turn-off power semiconductor device
Dispositif semi-conducteur de puissance pouvant être mis hors circuit

(30) Priorität: 03.06.1986 CH 2233/86
(43) Veröffentlichungstag der Anmeldung: 16.12.1987
(73) Patentinhaber: BBC Brown Boveri AG, CH-5401 Baden (CH)
(72) Erfinder: Grüning, Horst, Dr., CH-5404 Baden (CH)

(56) Entgegenhaltungen:
- EP-A- 0 038 248
- EP-A- 0 121 068
- EP-A- 0 178 387
- US-A- 4 037 245
- US-A- 4 476 622
- PATENT ABSTRACTS OF JAPAN, Band 7, Nr. 13 (E-153)[1158], 19. Januar 1983; & JP-A-57 172 765 (HANDOUTAI KENKIYUU SHINKOUKAI) 23-10-1982
- PATENT ABSTRACTS OF JAPAN, Band 7, Nr. 136 (E-181)[1281], 14. Juni 1983; & JP-A-58 50 775 (MITSUBISHI DENKI K.K.) 25-03-1983
- PATENT ABSTRACTS OF JAPAN, Band 7, Nr. 17 (E-154)[1162], 22. Januar 1983; & JP-A-57 173 974 (HITACHI SEISAKUSHO K.K.) 26-10-1982

## Beschreibung

Die vorliegende Erfindung betrifft ein abschaltbares Leistungshalbleiterbauelement in Form eines feldgesteuerten Thyristors gemäss dem Oberbegriff des Anspruchs 1. Ein solches Bauelement ist z.B. in der EP-A2 0 178 387 beschrieben.

Feldgesteuerte Leistungshalbleiterbauelemente sind mit unterschiedlichen Strukturen und unter verschiedenen Bezeichnungen bekannt. Innerhalb dieser Gruppe von bekannten Bauelementen werden im wesentlichen zwei Funktionstypen unterschieden, nämlich unipolare Strukturen wie z.B. Feldeffekttransistoren vom MOSFET- oder JFET-Typ mit Majoritätsträgerleitung, sowie Bauelemente mit bipolarer Trägerinjektion wie z.B. der feldgesteuerte Thyristor FCTh (Field Controlled Thyristor) oder der statische Induktionsthyristor SITh (Static Induction Thyristor).

Für Anwendungen im Bereich hoher Leistungen sind aus physikalischen Gründen vor allem die letztgenannten bipolaren Strukturen von Interesse, deren Wirkungsweise in der eingangs genannten Druckschrift dargestellt ist.

Diese Wirkungsweise der bekannten Strukturen beruht in der Regel auf der Anwendung des JFET (Junction Field Effect Transistor)-Prinzips für die Steuerung: In fein verteilten, mit Kathodenbereichen abwechselnden Gate- oder Steuerzonen werden durch Anlegen einer entsprechenden Gatespannung durch den Aufbau einer sich ausbreitenden Raumladungszone Gebiete mit Ladungsträgerverarmung erzeugt, die sich mit steigender Gatespannung in ein den Strom leitendes Kanalgebiet ausdehnen und schliesslich durch Abschnüren des Kanalgebiets den Stromfluss unterbrechen bzw. abschalten.

Der feldgesteuerte Thyristor befindet sich bei fehlender Gatespannung im Durchlasszustand (ON-Zustand) und wird erst durch Anlegen einer geeigneten Gatespannung abgeschaltet. Für die Dimensionierung und den Aufbau einer solchen Thyristorstruktur bedeutet dies, dass im Durchlasszustand ein möglichst geringer Durchlasswiderstand (ON-Widerstand) erwünscht ist, um die bei vollem Stromfluss am Bauelement abfallende Leistung zu begrenzen. Andererseits sollte die Gate-Kathoden-Struktur des Bauelements so ausgelegt sein, dass eine möglichst gute Steuerbarkeit erreicht wird, d.h. mit kleinen Gatespannungen und -strömen hohe Leistungen geschaltet werden können.

Ausgehend von einer aus der EP-A1 0 121 068 bekannten Struktur eines FCTh, bei der die p-dotierten Gatebereiche auf den Böden der Gräben angeordnet sind, welche die einzelnen Kathodenfinger voneinander trennen, ist in der EP-A2 0 178 387 vorgeschlagen worden, die p-dotierten Gatebereiche auf die Grabenwände auszudehnen, um so eine Verbesserung der Blockierverstärkung und damit der Steuerbarkeit des FCTh zu erreichen.

Mit diesen auf die Grabenwände erweiterten Gatebereichen wird eine Feldsteuerung über die gesamte Tiefe des im Kathodenfinger verlaufenden Kanals erzielt. Dadurch ist ein Abschalten des jeweiligen Kathodenfingers mit hinreichend kleinen Gatespannungen gewährleistet.

Die mit den erweiterten Gatebereichen erzielte Verbesserung in den Steuereigenschaften bringt für das Durchlassverhalten des Thyristors allerdings Probleme mit sich: Im ON-Zustand wird der n-dotierte Kanal im Kathodenfinger nicht mit Ladungsträgern überschwemmt, da die von der Anode injizierten Löcher über die p-dotierten Gatebereiche in den Grabenwänden abfliessen. Aus dieser Ladungsträger-Verarmung im Kanalgebiet resultiert ein hoher ON-Widerstand, obgleich die Gateelektrode nicht auf festem Potential liegt ("floating Gate").

Aufgabe der vorliegenden Erfindung ist es nun, einen feldgesteuerten Thyristor mit der feinunterteilten Gate-Kathoden-Struktur zu schaffen, der eine verbesserte Steuerfähigkeit aufweist, ohne die Durchlasseigenschaften negativ zu beeinflussen.

Die Aufgabe wird bei einem abschaltbaren Leistungshalbleiterbauelement der eingangs genannten Art durch die Merkmale aus dem Kennzeichen des Anspruchs 1 gelöst.

Der Kern der Erfindung besteht darin, im Bereich der Grabenwände zusätzlich Mittel zur Steuerung vorzusehen, die jedoch so ausgebildet sind, dass der ON-Widerstand nicht oder nicht wesentlich vergrössert wird.

Diese Mittel umfassen erfindungsgemäss Wandschichten in den Grabenwänden, die eine deutlich geringere p-Dotierung aufweisen als die eigentlichen Gatebereiche.

Die Erfindung soll nun nachfolgend anhand der Ausführungsbeispiele im Zusammenhang mit der Zeichnung näher erläutert werden. Es zeigen:
- Fig. 1: den Ausschnitt aus einer bekannten FCTh-Struktur mit auf die Grabenwände erweiterten Gatebereichen im Querschnitt,
- Fig. 2: den Querschnitt durch einen Kathodenfinger einer bekannten FCTh-Struktur ohne zusätzliche Steuerungsmittel im Bereich der Grabenwände, und
- Fig. 3: den Querschnitt durch einen Kathodenfinger mit zusätzlichen Steuerungsmitteln im Bereich der Grabenwände gemäss einem Ausführungsbeispiel der Erfindung.

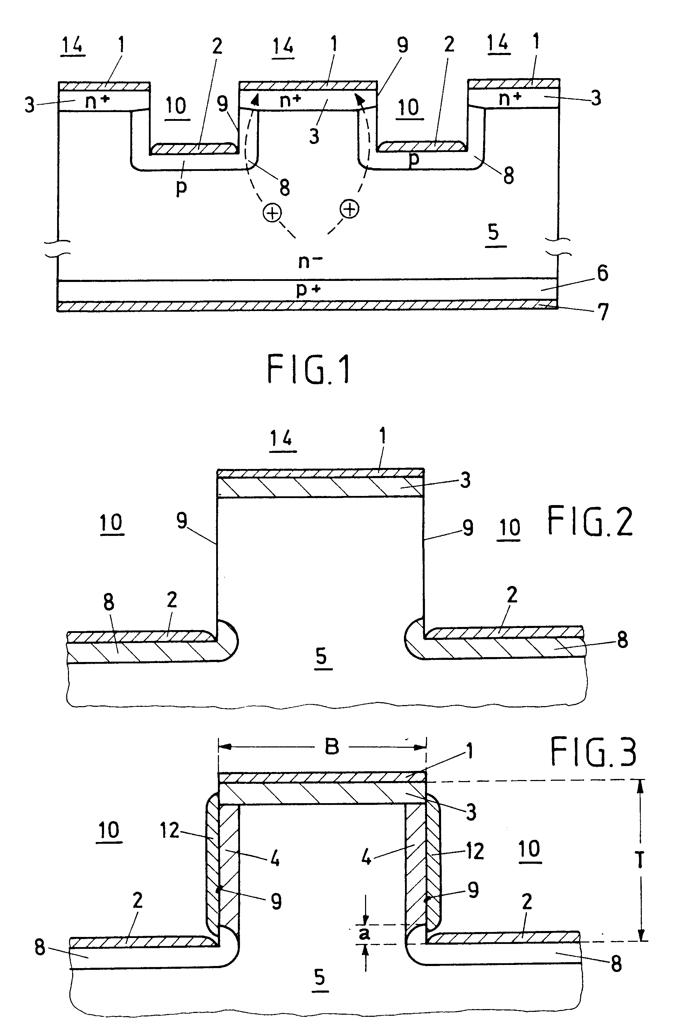

In Fig. 1 ist ausschnittsweise die Struktur des aus der EP-A1 0 178 387 bekannten FCTh im Querschnitt dargestellt.

Zwischen einem metallischen Anodenkontakt 7 auf der Anodenseite und metallischen Kathodenkontakten 1 auf der Kathodenseite ist eine Folge von unterschiedlich dotierten Schichten angeordnet, die eine p⁺-dotierte Anodenschicht 6, eine n⁻-dotierte Kanalschicht 5 und n⁺-dotierte Kathodenbereiche 3 umfasst.

Die einzelnen Kathodenbereiche 3 sind voneinander durch tiefe schmale Gräben 10 getrennt und bilden zusammen mit den jeweils darunterliegenden Bereichen der Kanalschicht 5 einzelne schmale Kathodenfinger 14. In die Böden der Gräben 10 und in die Grabenwände 9 sind p-dotierte Gatebereiche 8 eingelassen und im Bereich der Grabenböden mit metallischen Gatekontakten 2 versehen.

Wird nun an die Gatekontakte 2 eine negative Gatespannung angelegt, bildet sich an dem PN-Uebergang zwischen Gatebereich 8 und Kanalschicht 5 eine Raumladungszone, die sich mit zunehmender Gatespannung in das in den Kathodenfingern 14 vorhandene Kanalgebiet ausdehnt und das Gebiet von Ladungsträgern entleert. Da dieser Steuerungseffekt durch die auf die Grabenwände 9 erweiterten Gatebereiche 8 praktisch über die gesamte Tiefe der Kathodenfinger wirksam wird, werden durch diese bekannte Struktur besonders vorteilhafte Steuerungseigenschaften erzielt.

Im ON-Zustand des Bauelements machen sich die erweiterten Gatebereiche 8 jedoch nachteilig bemerkbar. Wie in Fig. 1 durch die gestrichelten Pfeile angedeutet, wird der Kanal im Kathodenfinger 14 im ON-Zustand nicht mit frei beweglichen Ladungsträgern, hier Löchern, überschwemmt, weil diese aus der Anodenschicht 6 in die Kanalschicht 5 injizierten Löcher (in Fig. 1 durch die mit "+" versehenen Kreise dargestellt) in Richtung der Pfeile über die erweiterten p-dotierten Gatebereiche 8 in den Grabenwänden 9 zur Kathodenseite abfliessen. Da das Kanalgebiet aber nicht mit Ladungsträgern überschwemmt wird, weist es einen relativ hohen Widerstand auf, der sich als erhöhter ON-Widerstand des Bauelements bemerkbar macht.

Die vorliegende Erfindung geht nun aus von einer Gate-Kathodenkonfiguration, wie sie ausschnittsweise für einen Kathodenfinger 14 in Fig. 2 dargestellt und aus der EP-A1 0 121 068 bekannt ist. Hier sind die Gatebereiche 8 im wesentlichen auf die Böden der Gräben 10 beschränkt.

Im Bereich der Grabenwände 9 werden erfindungsgemäss zusätzlich Mittel zur Steuerung vorgesehen, die, im Unterschied zu der bekannten Lösung mit den erweiterten Gatebereichen den ON-Widerstand des Bauelements nicht oder nicht wesentlich vergrössern.

Ein Ausführungsbeispiel für die Ausgestaltung der zusätzlichen Mittel nach der Erfindung ist in Fig. 3 wiedergegeben. In diesem Ausführungsbeispiel sind in die Grabenwände 9 Wandschichten 4 eingelassen (eindiffundiert), die von den Gatebereichen 8 bis zum Kathodenbereich 3 reichen.

Die Wandschichten 4 sind wie die Gatebereiche 8 p-dotiert. Im Unterschied zur bekannten Lösung aus Fig. 1 sind jedoch die beiden p-Dotierungen in ihrer Konzentration nicht gleich, sondern abgestuft, wobei die Wandschichten 4 eine deutlich geringere Dotierungskonzentration aufweisen als die Gatebereiche 8.

Diese Abstufung in der Dotierungskonzentration hat zur Folge, dass beträchtlich weniger Löcher aus dem Kanalgebiet des Kathodenfingers 14 abgezogen und über die Wandschichten 4 zur Kathode abgeleitet werden.

Ein vergleichbarer Effekt lässt sich auch erreichen, wenn anstelle der Abstufung der Dotierungskonzentration die Wandschichten 4 in ihrer Dicke verringert werden. Auch in diesem Fall wird der Widerstand der Wandschichten 4 entlang der Grabenwände 9 so vergrössert, dass der ON-Widerstand des Bauelements durch Abziehen von Ladungsträgern aus dem Kanalgebiet nicht wesentlich vergrössert wird.

Zur Verbesserung der Durchlasseigenschaften in der Ausführung der Fig. 3 stehen demnach zwei Parameter zur Verfügung, die unabhängig voneinander in geeigneter Weise gewählt werden können: die Dicke der Wandschicht 4 und ihre Dotierungskonzentration.

Zur Verdeutlichung der Erfindung sei nachfolgend ein Dimensionierungsbeispiel angegeben, dass sich auf eine abgestufte Dotierungskonzentration bezieht:

| | |
|---|---|
| Fingerbreite B: | 30 µm |
| Grabentiefe T: | 35 µm |
| Dicke des Kathodenbereichs 3: | 4 µm |
| Dicke der Wandschichten 4: | 4 µm |
| Ueberhang a der Gatebereiche 8: | 10 µm |
| Rand-Dotierungskonzentration in den Gatebereichen 8: | 4 · 10¹⁶cm⁻³ |
| Rand-Dotierungskonzentration in den Wandschichten 4: | 3 · 10¹⁵cm⁻³ |

Eine allgemeine Bedingung für die Dimensionierung der Wandschichten 4 kann in der folgenden Weise definiert werden:
Dicke und Dotierungskonzentration der Wandschichten 4 müssen so gewählt sein, dass
(a) bei Vollast, d.h., bei vollem Strom im Durchlasszustand weniger als 1/3 des Löcherstromes, der an dem Kathodenfinger ankommt, über die Wandschichten 4 zur Kathode abgeführt werden, und
(b) beim maximal auftretendem elektrischen Feld die Wandschichten 4 noch nicht vollständig von Ladungsträgern ausgeräumt sind, d.h., die Raumladungszone des PN-Uebergangs zwischen Wandschicht 4 und Kanalschicht 5 noch nicht an den Grabenwänden 9 anstösst.

Hinsichtlich der Gatebereiche 8 kann die Dimensionierung aus dem bereits genannten Stand der Technik übernommen werden.

Beim Ausführungsbeispiel der Fig. 3 müssen die Grabenwände 9 metallfrei sein, um nicht den beabsichtigten hohen Widerstand der Wandschichten 4 kurzzuschliessen und damit den angestrebten Erfolgt zunichte zu machen.

Sollte gleichwohl bei der Herstellung des Bauelements die Metallisierung der Gatekontakte 2 sich aus technologischen Gründen nicht nur auf die Grabenböden beschränken (wie in Fig. 3 dargestellt), sondern sich auch über die Seitenwände erstrecken, ist es erforderlich, die Wandschichten 4 durch auf den Grabenwänden 9 aufgetragene Wandabdeckungsschichten 12 aus isolierendem Material, z.B. SiO₂, vor einem Kurzschluss zu schützen.

Insgesamt ergibt sich nach der Erfindung ein abschaltbares Leistungshalbleiterbauelement, dass bei guten Steuerungseigenschaften durch einen niedrigen ON-Widerstand ausgezeichnet ist und vergleichsweise einfach hergestellt werden kann.

## Patentansprüche

1. Abschaltbares Leistungshalbleiterbauelement in Form eines feldgesteuerten Thyristors (FCTh), mit einer p-leitenden Anodenschicht (6), einer darüberliegenden, n-leitenden Kanalschicht (5), und einer Mehrzahl von auf der Kathodenseite abwechselnd angeordneten, n-leitenden Kathodenbereichen (3) und p-leitenden Gatebereichen (8), wobei die Kathodenbereiche (3) auf durch Gräben (10) voneinander getrennten Kathodenfingern (14) angeordnet sind, und sich die Gatebereiche (8) über die Böden der Gräben (10) erstrecken, und im Bereich der Grabenwände (9) p-dotierte Wandschichten (4) eingelassen sind, welche von den Kathodenbereichen (3) bis zu den benachbarten Gatebereichen reichen, dadurch gekennzeichnet, dass die Wandschichten (4) eine deutlich geringere Dotierungskonzentration oder Dicke aufweisen als die Gatebereiche (8).

2. Bauelement nach Anspruch 1, dadurch gekennzeichnet, dass die Wandschichten (4) derart dimensioniert sind, dass
(a) bei Vollast weniger als 1/3 des Löcherstromes, der in den Kathodenfingern (14) ankommt, über die Wandschichten (4) zur Kathode des Bauelements abgeführt wird; und
(b) beim grössten auftretenden elektrischen Feld die Ladungsträger aus den Wandschichten (4) noch nicht vollständig ausgeräumt sind.

3. Bauelement nach Anspruch 2, dadurch gekennzeichnet, dass
(a) die Kathodenbereiche (3) jeweils eine Breite (B) von etwa 30 µm;
(b) die Gräben (10) jeweils eine Tiefe (T) von etwa 35 µm;
(c) die Gatebereiche (8) eine Rand-Dotierungskonzentration von etwa 4 x 10¹⁶ cm⁻³ ; und
(d) die Wandschichten (4) jeweils eine Dicke von etwa 4 µm und eine Rand-Dotierungskonzentration von etwa 3 x 10¹⁵ cm⁻³
aufweisen.

4. Bauelement nach einem der Ansprüche 1 bis 3, dadurch gekennzeichnet, dass die Wandschichten (4) durch Wandabdeckungsschichten (12) abgedeckt sind, welche auf die Grabenwände (9) aufgebracht sind und vorzugsweise aus SiO₂ bestehen.

## Claims

1. Gate turn-off power semiconductor component in the form of a field-controlled thyristor (FCTh), with a p-type anode layer (6), an n-type channel layer (5) situated on top of it and a multiplicity of n-type cathode regions (3) and p-type gate regions (8) disposed in an alternating manner on the cathode side, the cathode regions (3) being disposed on cathode fingers (14) separated from each other by trenches (10) and the gate regions (8) extending over the floors of the trenches (10), and p-doped wall layers (4) being introduced in the region of the trench walls (9), which wall layers (4) extend from the cathode regions (3) down to the adjacent gate regions, characterised in that the wall layers (4) have a markedly lower doping concentration or thickness than the gate regions (8).

2. Component according to Claim 1, characterised in that the wall layers (4) are dimensioned such that
(a) at maximum load less than 1/3 of the hole current arriving in the cathode fingers (14) is drained away via the wall layers (4) to the cathode of the component; and
(b) the charge carriers are still not completely depleted from the wall layers (4) at the maximum electric field which occurs.

3. Component according to Claim 2, characterised in that
(a) the cathode regions (3) each have a width (B) of about 30 µm;
(b) the trenches (10) each have a depth (T) of about 35 µm;
(c) the gate regions (8) have an edge doping concentration of about 4 × 10¹⁶ cm⁻³; and
(d) the wall layers (4) each have a thickness of about 4 µm and an edge doping concentration of about 3 × 10¹⁵ cm⁻³.

4. Component according to one of Claims 1 to 3, characterised in that the wall layers (4) are coated with wall coating layers (12) which are deposited on the trench walls (9) and consist preferably of SiO₂.

## Revendications

1. Composant semi-conducteur de puissance déclenchable sous la forme d'un thyristor commandé par le champ (FCTh), comportant une couche d'anode de conductivité p (6), une couche de canal sus-jacente de conductivité n (5) et une pluralité de domaines de cathode de conductivité n (3) et de domaines de gâchette de conductivité p (8), disposés en alternance du côté cathodique, les domaines de cathode (3) étant disposés sur des doigts de cathode (14) séparés les uns des autres par des fosses (10) et les domaines de gâchette (8) s'étendant sur le fond des fosses (10), et dans le domaine des parois de fosses (9) étant insérées des couches de paroi à dopage p (4) qui s'étendent des domaines de cathode (3) jusqu'aux domaines de gâchette voisins, caractérisé en ce que les couches de paroi (4) présentent une concentration en agent dopant ou une épaisseur nettement plus faible que les domaines de gâchette (8).

2. Composant suivant la revendication 1, caractérisé en ce que les couches de paroi (4) sont dimensionnées d'une manière telle que
(a) à pleine charge, moins de 1/3 du courant de trou, qui parvient dans les doigts de cathode (14), est évacué par l'intermédiaire des couches de paroi (4) vers la cathode du composant; et que
(b) dans le cas du plus grand champ électrique rencontré, les porteurs de charge ne sont pas encore complètement évacués des couches de paroi (4).

3. Composant suivant la revendication 2, caractérisé en ce que
(a) les domaines de cathode (3) ont chacun une largeur (B) d'environ 30 µm;
(b) les fosses (10) ont chacune une profondeur (T) d'environ 35 µm;
(c) les domaines de gâchette (8) ont une concentration en agent dopant de bord d'environ 4 × 10¹⁶ cm⁻³; et
(d) les couches de paroi (4) ont chacune une épaisseur d'environ 4 µm et une concentration en agent dopant de bord d'environ 3 × 10¹⁵ cm⁻³.

4. Composant suivant l'une quelconque des revendications 1 à 3, caractérisé en ce que les couches de paroi (4) sont recouvertes par des couches de recouvrement de paroi (12) qui sont appliquées aux parois (9) des fosses et sont de préférence en SiO₂.
